# EUROPEAN PATENT SPECIFICATION

(11) **EP 0 452 888 B1**
(45) Date of publication and mention of the grant of the patent: **21.08.1996**
(21) Application number: 91106070.5
(22) Date of filing: 16.04.1991
(51) Int. Cl.: H01L 21/285, H01L 21/324

(54) **Process for forming a layer of titanium silicide on a semiconductor wafer**
Verfahren zum Herstellen einer Titansilizidschicht auf einer Halbleiterschicht
Procédé de formation d'une couche de siliciure de titane sur une plaquette semi-conductrice

(30) Priority: 16.04.1990 US 510340; 16.04.1990 US 510307; 16.04.1990 US 509928
(43) Date of publication of application: 23.10.1991
(73) Proprietor: APPLIED MATERIALS, INC., Santa Clara California 95054-3299 (US)
(72) Inventor: Nulman, Jaim, Palo Alto, CA 94306 (US)
(74) Representative: Diehl, Hermann O. Th., Dr.

(56) References cited:
- EP-A- 0 272 141
- GB-A- 2 181 297
- JOURNAL OF THE ELECTROCHEMICAL SOCIETY. vol. 136, no. 1, January 1989,
- MANCHESTER, NEW HAMPSHIRE US pages 238 - 241; C. MALLARDEAU ET.AL.: 'CHARACTERISATION OF TiSi2 OHMIC AND SCHOTTKY CONTACTS FORMAD BY RAPID THERMAL ANNEALING TECHNOLOGY'
- * the whole document *

## Description

### PROCESS FOR FORMING A LAYER OF TITANIUM SILICIDE ON A SEMICONDUCTOR WAFER

This invention relates to the processing of a semiconductor wafer to form an integrated circuit structure thereon. More particularly, this invention relates to a process for forming a layer of titanium silicide on a semiconductor wafer.

In the conventional formation of a titanium silicide layer, as a part of an integrated circuit structure on a semiconductor wafer such as a silicon wafer, those surfaces of the wafer on which the titanium silicide layer is to be formed are first cleaned to remove any materials which might interfere with reaction between the subsequently deposited titanium layer and the exposed silicon portions of the wafer. The surfaces are conventionally cleaned in a vacuum chamber using an inert gas such as argon with an rf plasma. This is sometimes preceded by an oxide wet etch.

Following these cleaning steps, a layer of titanium metal is conventionally deposited over the cleaned wafer structure, for example, using a vacuum sputtering deposition (PVD) process, usually to a thickness ranging from about 100 to about 1000 Angstroms*.
* 1 Angstrom = 0.1 nm

The titanium coated wafer is then conventionally removed from the PVD chamber and transported through the ambient atmosphere to separate annealing apparatus where the structure is annealed in a nitrogen atmosphere and in the absence of oxygen (which would react with the titanium). Usually this annealing step comprises a rapid anneal where the structure is rapidly heated to the annealing temperature of from about 650°C to about 675°C in a few seconds and then maintained at this annealing temperature for from about 20 to about 60 seconds.

The nitrogen atmosphere used in this annealing step results in the simultaneous formation of a titanium nitride layer as the titanium reacts with the silicon to form titanium silicide. This titanium nitride acts as a blocking layer to prevent migration of silicon atoms to the surface, from the underlying silicon.

Following this anneal step, the wafer is conventionally removed from the annealing chamber and subjected to a wet etch to remove the titanium nitride blocking layer, as well as any remaining unreacted titanium. The etched wafer is then annealed again, however at a higher temperature of from about 800°C to about 900°C, to convert the less stable C49 phase titanium silicide formed during the first annealing step to the more stable C54 phase.

The reason for annealing at a lower temperature during the first annealing step is to inhibit the formation of titanium oxide, (for example, by breakdown of the silicon oxide (SiO₂) comprising insulated regions on the surface of the wafer and reaction of the resulting oxygen with titanium), as well as to permit formation of the desired blocking layer of titanium nitride over the surface.

The reason for conducting the etching step prior to the second, higher temperature, anneal is to ensure removal from the wafer of any unreacted titanium, particularly unreacted titanium remaining over insulated areas, which might otherwise result in reaction with oxygen from the silicon oxide during the higher temperature anneal. Such unreacted titanium can be the result of the presence of titanium oxides on the surface of the titanium layer which shield underlying portions of the titanium layer over the insulated regions of the wafer from reaction with the nitrogen gas present in the annealing chamber during the first annealing step.

The document JOURNAL OF THE ELECTROCHEMICAL SOCIETY, vol. 136, no. 1, January 1989, MANCHESTER, NEW HAMPSHIRE, USA, pages 238 - 241; C. MALLARDEAU ET AL: CHARACTERIZATION OF TiSi₂ OHMIC AND SCHOTTKY CONTACTS FORMED BY RAPID THERMAL ANNEALING TECHNOLOGY discloses the sputter deposition of titanium and subsequent anneal at 700°C to produce a layer of titanium silicide exhibiting improved sheet resistance. The document does not teach the importance of avoiding exposure to oxygen or oxygen containing gases, nor does it teach the formation of a titanium nitride layer.

It would, however, be desirable to provide a process for the formation of a titanium silicide layer on a semiconductor wafer wherein a single annealing step could be utilized, prior to the etching step, to avoid removing the wafer from the annealing chamber, wet etching the wafer, drying the wafer, and then reintroducing the etched wafer back to the annealing chamber for a second annealing step.

It is, therefore, an object of this invention to provide an improved process for the formation of titanium silicide on a semiconductor wafer wherein a single annealing step is used to form a stable phase of titanium silicide on the wafer surface, without, however, forming titanium oxide on the wafer and/or titanium silicide over oxide portions of the wafer. This object is solved by the process of independent claim. Further advantageous features and details of the invention are evident from the dependent claims, the description and the drawings.

It is another object of this invention to provide an improved process for the formation of titanium silicide on a semiconductor wafer wherein oxygen is sufficiently excluded from the process to permit forming the titanium silicide, together with the desired blocking layer of titanium nitride, as well as reacting with nitrogen all of the titanium overlying oxide surfaces on the wafer, at a first annealing temperature; and then raising the annealing temperature to convert the unstable C49 phase titanium silicide to the stable C54 phase prior to an etching step to remove the titanium nitride from the wafer.

It is still another aspect of this invention to provide an improved process for the formation of titanium silicide on a semiconductor wafer wherein oxygen and/or oxygen-bearing gases are excluded from the process by transferring the wafer from a titanium deposition chamber to an annealing chamber without exposing the titanium coated wafer to oxygen or oxygen-bearing gases which would inhibit penetration of nitrogen atoms into the layer or inhibit formation of titanium nitride therein; then forming the titanium silicide, together with the desired blocking layer of titanium nitride, as well as reacting with nitrogen all of the titanium overlying oxide surfaces on the wafer, at a first annealing temperature; and then raising the annealing temperature to form a stable phase of titanium silicide prior to an etching step to remove the titanium nitride from the wafer.

It is yet a further aspect of this invention to provide an improved process for the formation of titanium silicide on a semiconductor wafer wherein oxygen-bearing gases such as air are further excluded from the process by cleaning the wafer using a reactive rf ion etch prior to depositing a layer of titanium on the wafer; transferring the wafer from the cleaning chamber to a titanium deposition chamber under vacuum without exposing the titanium coated wafer to oxygen-bearing gases; then transferring the wafer from the titanium deposition chamber to an annealing chamber under vacuum without exposing the titanium coated wafer to oxygen or oxygen-bearing gases; then forming the titanium silicide, together with the desired blocking layer of titanium nitride, as well as reacting with nitrogen all of the titanium overlying oxide surfaces on the wafer, at a first annealing temperature; and then raising the annealing temperature to form a stable phase of titanium silicide prior to an etching step to remove the titanium nitride from the wafer.

These and other details of the invention will be apparent from the following description and accompanying drawings.

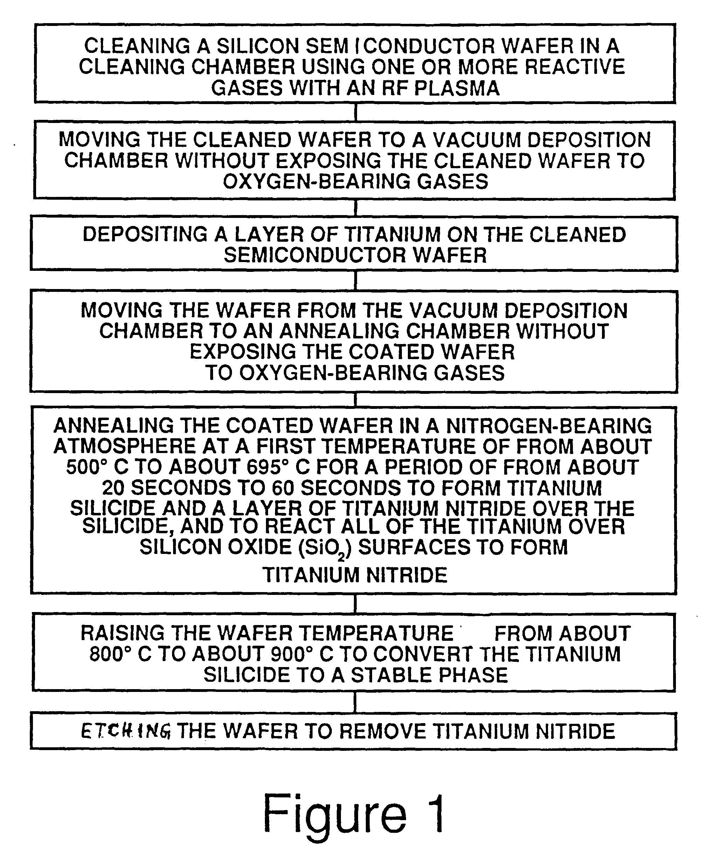

Figure 1 is a flowsheet illustrating an embodiment of the process of the invention.

Figure 2 is a top view of an apparatus suitable for carrying out the process of the invention.

Figures 3-6 are sequential fragmentary vertical cross-sectional views illustrating formation of a titanium silicide layer formed on a silicon wafer using the process of the invention.

The process of the invention provides for the formation of a titanium silicide layer on a semiconductor wafer, in a nitrogen-bearing atmosphere and in the substantial absence of oxygen-bearing gases such as air, using a single annealing step in which all of the titanium over oxide portions of the wafer are converted to titanium nitride and which permits formation of a sufficient amount of a titanium nitride layer to block the migration of unreacted silicon atoms to the surface, while also forming a stable phase of titanium silicide.

By use of the expressions herein "substantial absence of oxygen-bearing gas" and/or "without substantially exposing the newly formed titanium layer to oxygen and/or oxygen-bearing gases" is meant that in the chambers respectively used for the titanium deposition and for annealing, as well as in the vacuum chamber used for the transfer of the wafer therebetween, the atmosphere will contain less than 10 ppm oxygen in any of the chambers.

By use of the term herein "in a nitrogen-bearing atmosphere" is meant an atmosphere containing at least 10 volume % nitrogen. The nitrogen may come from N₂ or from any other nitrogen-containing source which will decompose to provide a source of nitrogen without adding oxygen-bearing gases to the atmosphere, e.g., NH₃.

By use of the term "unreacted silicon atoms" is generally meant silicon which has not reacted with titanium to form the corresponding silicide - or which is not already oxidized to form silicon oxide such as the SiO₂ insulation regions of the semiconductor wafer under portions of the deposited titanium layer.

In one aspect, the process of the invention includes the transfer of the semiconductor wafer, under vacuum and in the substantial absence of oxygen-bearing gases, from a titanium deposition chamber and to an annealing chamber, to inhibit or exclude oxygen in and/or on the newly formed titanium layer on the semiconductor wafer during the annealing portion of the process, which is then carried out in a single step at a first temperature to convert all of the titanium overlying oxide portions of the wafer to titanium nitride and to form the titanium silicide and the blocking layer of titanium nitride thereon, and then at a higher second temperature to convert the titanium silicide into a stable phase, prior to removal of the titanium nitride in a subsequent etching step.

In another aspect the process of the invention further includes the cleaning of the wafer, prior to the titanium deposition step, using a reactive rf ion etch to more thoroughly remove oxygen and/or oxygen-bearing gases from the wafer surface prior to the titanium deposition step, followed by moving the cleaned wafer from the cleaning chamber to the titanium deposition chamber without exposing the wafer to oxygen-bearing gases, then transferring the semiconductor wafer, under vacuum and in the substantial absence of oxygen-bearing gases, from the titanium deposition chamber to the annealing chamber, to inhibit or exclude oxygen in and/or on the newly formed titanium layer on the semiconductor wafer during the annealing portion of the process, which is then carried out in a single step at a first temperature to convert all of the titanium overlying oxide portions of the wafer to titanium nitride and to form the titanium silicide and the blocking layer of titanium nitride thereon, and then at a higher second temperature to convert the titanium silicide into a stable phase, prior to removal of the titanium nitride in a subsequent etching step.

The process of forming a titanium silicide layer on a semiconductor wafer, in the substantial absence of oxygen and/or oxygen-bearing gases such as air, is described and claimed in copending European Patent application No. EP-A-0 452 891 (attorney's file A5418-EP) assigned to the assignee of this invention and entitled "Process for Forming Titanium Silicide on a Semiconductor Wafer", which is incorporated by reference and copy of which is enclosed (Annex A). In that application there is described a process for forming titanium silicide on a semiconductor wafer wherein oxygen-bearing gases are excluded by the transfer of the semiconductor wafer, under vacuum and in the substantial absence of oxygen-bearing gases, from a titanium deposition chamber to an annealing chamber, as well as by the cleaning of the wafer, prior to the titanium deposition step, using a reactive rf ion etch to more thoroughly remove oxygen and/or oxygen-bearing gases from the wafer surface prior to the titanium deposition step, followed by transfer of the cleaned wafer, under vacuum and in the substantial absence of oxygen-bearing gases, to the titanium deposition chamber.

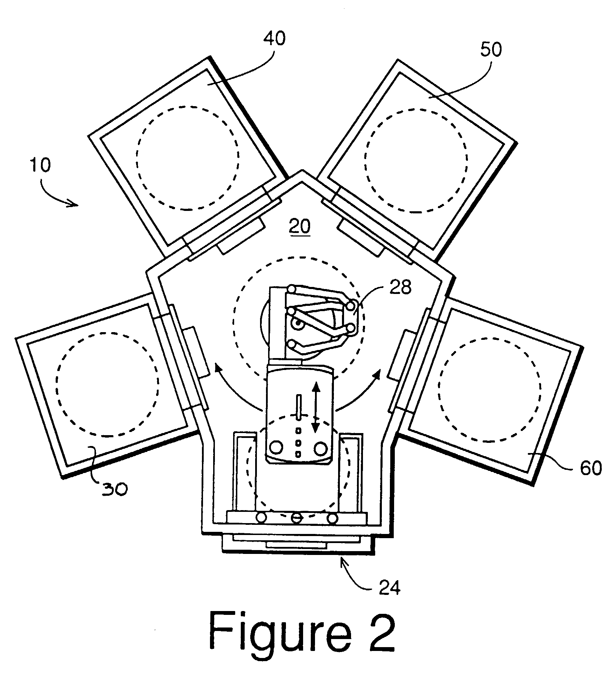

Turning now to Figure 2, apparatus useful for carrying out the process of the invention is generally indicated at 10 which comprises a sealed central chamber 20 into which a wafer may be loaded through a cassette load lock 24. Central chamber 20 may be maintained at a vacuum ranging from about 10⁻⁹ to about 10⁻⁵ Torr*. In particular, oxygen and other oxygen-bearing gases such as air are excluded from central chamber 20.
*1 Torr = 1.333 hPa

Robotic means 28 may be provided within central chamber 20 to transfer the wafer between a cleaning chamber 30, a PVD chamber 40, and an annealing chamber 50 through central chamber 20. An optional degassing chamber 60 may also be provided as a part of apparatus 10, which will also be accessible through central vacuum chamber 20.

Multi-chambered vacuum apparatus for the processing of semiconductor wafers is generally described in Toshima U.S. Patent 4,785,962, cross-reference to which is hereby made, and is commercially available, such as, for example, a 5000 Series wafer processing apparatus available from Applied Materials, Inc. in Santa Clara, CA, and such apparatus may be modified for the practice of the present invention.

In the practice of the process of the invention, a single wafer or a group of wafers on a tray is admitted into central chamber 20 of vacuum apparatus 10 through load lock 24 and then a single wafer is transferred to cleaning chamber 30 where the wafer is cleaned to remove any foreign materials from the wafer and, in particular, any oxides from the surface of the exposed silicon.

The wafer may be cleaned using a conventional inert gas rf etch, using argon as the inert gas. However, in accordance with a preferred embodiment of the process of the invention, the wafer is preferably cleaned using a reactive rf ion process such as a NF₃/argon mixture by flowing into cleaning chamber 30 from about 2 sccm to about 500 sccm of at least one reactive gas such as NF₃ and from about 10 sccm to about 1000 sccm of a carrier gas such as argon while maintaining a vacuum of from about 1 to about 50 milliTorr* in cleaning chamber 30 and an rf plasma at a power level ranging from about 20 to about 500 watts. The cleaning chamber is maintained at a temperature within a range of from about 27°C to about 200°C during the cleaning step which is carried out for a period of from about 1 to about 500 seconds.
*1 milliTorr = 0,133 Pa

Examples of reactive gases which can be used to carry out the reactive ion etch cleaning step of the invention include not only NF₃, but also fluorinated 1-2 carbon hydrocarbons such as, for example, CHF₃ and CF₄, as well as mixtures of same.

After the wafer has been cleaned, it is transferred out of cleaning chamber 30 back to central chamber 20 and then into deposition chamber 40 where a layer of titanium, having a thickness range of from about 100 to about 5000 Angstroms, preferably from about 100 to about 1000 Angstroms, and typically about 500 Angstroms, is conventionally deposited onto the wafer surface using, for example, a PVD sputtering process. It will be noted that in the preferred embodiment of the invention, the cleaned wafer removed from cleaning chamber 30 is not exposed to air or any other oxygen-containing gases, but is rather moved from cleaning chamber 30 through vacuum chamber 20 directly to deposition chamber 40.

After deposition of the titanium layer onto the wafer, the wafer is removed from deposition chamber 40 and, in accordance with the invention, directly transferred to annealing chamber 50 through vacuum chamber 20 without any exposure to oxygen or other oxygen-bearing gases, such as air, which might otherwise adsorb on or enter into the newly deposited titanium layer.

The annealing step of the process is then carried out by first annealing the wafer at a temperature ranging from about 500°C up to about 695°C, and preferably at a temperature ranging from about 600°C to about 675°C. The annealing step is preferably carried out under rapid anneal conditions where the wafer is ramped up to the initial annealing temperature at a rate of from about 5°C/second to about 150°C/second, typically about 80°C/second, and the wafer is subject to the first annealing temperature for a period of from about 20 to about 60 seconds. The temperature is then raised to from about 800°C to about 900°C for an additional period of from about 20 to 60 seconds. This higher anneal temperature serves to convert the less stable C49 phase titanium silicide formed at the first annealing temperature to the more stable C54 phase, as is well known to those skilled in this art.

During the annealing step, one or more nitrogen-bearing gases are flowed into annealing chamber 50 at a rate ranging from about 500 to about 10,000 sccm while maintaining the pressure in said annealing chamber within a range of from about 100 milliTorr to about 800 Torr.

In a preferred mode of practicing the claimed process of the invention, the annealing step is carried out while maintaining a nitrogen vacuum or pressure level of from about 100 milliTorr to about 100 Torr, preferably from about 500 milliTorr to about 10 Torr, and most preferably from about 1 Torr to about 10 Torr, as described and claimed in copending European Patent Application No. EP-A-0 452 889 (attorney's file A5420-EP),assigned to the assignee of this invention and entitled "Process for Forming Titanium Silicide on a Semiconductor Wafer", which is incorporated by reference and copy of which is enclosed (Annex B). This use of low nitrogen pressure during the annealing step, while still forming sufficient TiN to block migration of unreacted silicon to the surface and to passivate the TiN grain boundaries, as well as to convert all titanium overlying oxide regions of the wafer to titanium nitride, is made possible by the exclusion of exposure of the wafer to oxygen-bearing gases prior to the first anneal step in accordance with the practice of the invention claimed herein.

After the annealing step, the titanium nitride (TiN), formed over the titanium silicide as well as over silicon oxide (SiO₂) portions of the wafer, may be selectively removed using a wet etch such as a mixture of 4 parts by weight H₂O, 1 part by weight H₂O₂, and 1 part by weight NH₄OH which will remove titanium nitride in preference to titanium silicide and/or silicon oxide.

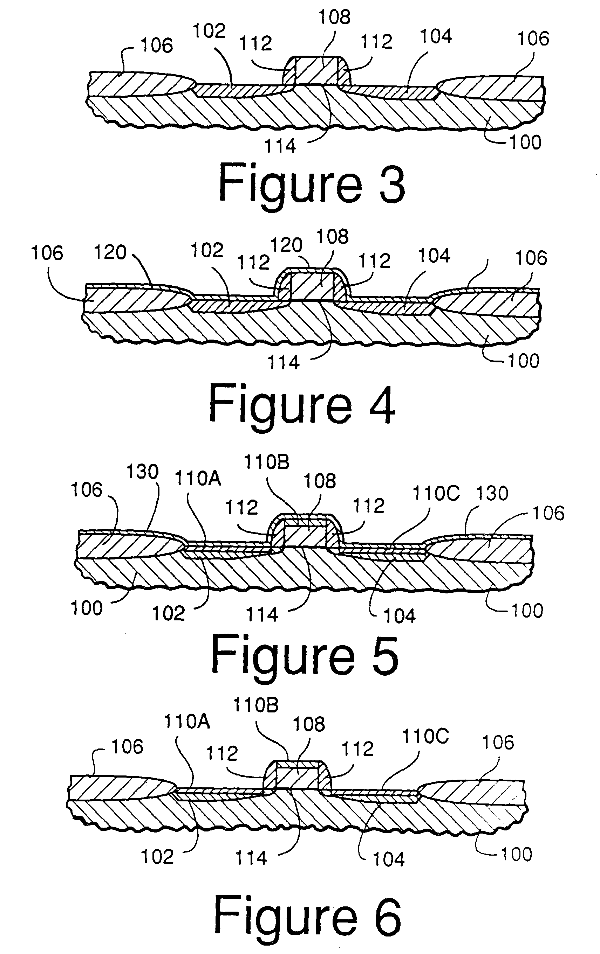

Referring now to Figures 3-6, a silicon semiconductor wafer 100 is shown having silicon oxide (SiO₂) isolation regions 106 previously formed in the surface of the wafer and an MOS structure comprising a source region 102, a drain region 104, and a gate electrode 108 formed over gate oxide 114 with oxide spacers 112 formed on the sidewalls of gate electrode 108. Titanium silicide will be formed over the source and drain regions and over the gate electrode as a part of the construction of the electrical contacts for the MOS device.

As previously described, the wafer is first cleaned to prepare the surface for deposition of titanium layer 120 which is shown deposited on the wafer structure in Figure 4. The titanium coated wafer is then moved to an annealing chamber, without exposing the titanium surface to oxygen-bearing gases.

Figure 5 shows the structure resulting from the annealing step. The titanium in those portions of titanium layer 120 in direct contact with silicon (either single crystal or polycrystalline silicon), i.e., the titanium over source region 102, drain region 104, and gate electrode 108, reacts with the silicon, at the lower annealing temperature, to form titanium silicide, as shown at 110A, 110B, and 110C. A layer of titanium nitride 130 is formed over the entire structure by reaction between titanium layer 120 and the nitrogen-bearing gas present in the annealing chamber.

It should be noted that all of the titanium in those portions of layer 120 overlying isolation oxide regions 106 and oxide spacers 112 reacts with the nitrogen to form titanium nitride at the lower annealing temperature so that when the annealing temperature is then raised, there is no unreacted titanium over the oxide regions available to react with the silicon oxide at the higher annealing temperature to form titanium silicides and/or titanium oxides over the silicon oxide regions of the structure.

While it is not the intention to be bound by any theories of operation, the total reaction with nitrogen of all of the titanium overlying the oxide areas during the first, lower temperature annealing, which makes it feasible to perform all of the annealing in a single step, is thought to be made possible by the exclusion of oxygen-bearing gases from the process which might otherwise form titanium oxides which would interfere with complete reaction between nitrogen and the titanium overlying the oxide regions, leaving unreacted titanium to react with the silicon oxides at the higher annealing temperature.

The final structure is shown in Figure 6, after removal of the titanium nitride layer by the previously described wet etch. No titanium reaction products remain over oxide surfaces 106 and 112, while titanium silicide portions 110A, 110B, and 110C are left, respectively over source region 102, drain region 104, and gate electrode 108.

Thus, the invention provides an improved process for forming a layer of titanium silicide on the surface of a semiconductor wafer using a single annealing step wherein excluding oxygen and/or oxygen-bearing gases such as air from the wafer, after deposition of the titanium layer thereon, results in the complete reaction with nitrogen, at the lower annealing temperature, of all of the titanium overlying oxide regions of the silicon semiconductor wafer, thus permitting subsequent annealing at a higher temperature to form a more stable phase of titanium silicide without first removing the titanium nitride layer. The exclusion of oxygen-bearing gases from the process further results in formation of a titanium silicide coating having more nitrogen on the surface, and deeper penetration of the nitrogen into the titanium silicide layer, resulting in more adequate formation of a titanium nitride blocking layer over the titanium silicide at the first annealing temperature whereby essentially no unreacted silicon migrates to the surface from or through the newly formed titanium silicide layer.

According to a special aspect of the invention, the improved process for forming titanium silicide on a silicon semiconductor wafer using a single annealing step which comprises:
a) providing a silicon semiconductor wafer having one or more silicon surface regions on which said titanium silicide is to be formed;
b) cleaning said wafer in a sealed cleaning chamber using an rf plasma and a gaseous mixture which includes at least one reactive gas;
c) transferring the cleaned wafer to a vacuum deposition chamber without substantially exposing said cleaned wafer to oxygen-bearing gases by transferring said wafer through a sealed central chamber which is interconnected to both said vacuum deposition chamber and said cleaning chamber;
d) forming a titanium layer over said cleaned wafer in said vacuum deposition chamber in the substantial absence of oxygen-bearing gases;
e) transferring the titanium coated wafer to an annealing station without substantially exposing the newly formed titanium layer to oxygen-bearing gases by transferring said wafer through a sealed central chamber which is interconnected to both said vacuum deposition chamber and said sealed annealing chamber; and
f) annealing the titanium-coated silicon semiconductor wafer in a nitrogen-bearing atmosphere in said annealing station, and in the substantial absence of oxygen-bearing gases, by initially heating said wafer to a first temperature ranging from about 500°C up to about 695°C for a time period ranging from about 20 seconds to about 60 seconds by raising the temperature of said wafer at a rate within a range of from about 5°C/second to about 150°C/second to form titanium silicide, and to form titanium nitride over said titanium silicide and over silicon oxide (SiO₂) surfaces on said wafer, and then further annealing said wafer at a second temperature ranging from about 800°C to about 900°C for an additional time period ranging from about 20 to about 60 seconds to convert said titanium silicide to a stable phase.

In the process of this aspect, advantageously said first annealing temperature ranges from about 600°C to about 675°C.

In the process of this aspect, further preferably all of the titanium overlying silicon oxide (SiO₂) regions on said wafer are reacted with nitrogen in said annealing chamber during said annealing at said first temperature to form titanium nitride whereby subsequent annealing of said wafer at said second higher temperature will not result in reaction between said silicion oxide and unreacted titanium overlying said silicon oxide.

According to a further special aspect of the invention, the improved process for forming titanium silicide on a silicon semiconductor wafer using a single annealing step comprises the following steps:
a) providing a silicon semiconductor wafer having one or more silicon surface regions on which said titanium silicide is to be formed;
b) cleaning said wafer in a sealed cleaning chamber using an rf plasma and a gaseous mixture containing at least one reactive gas;
c) transferring the cleaned wafer to a vacuum deposition chamber without substantially exposing said cleaned wafer to oxygen-bearing gases by transferring said wafer through a sealed central chamber which is interconnected to both said vacuum deposition chamber and said cleaning chamber;
d) forming a titanium layer over said cleaned wafer in said vacuum deposition chamber in the substantial absence of oxygen-bearing gases;
e) transferring the titanium coated wafer to an annealing station without substantially exposing the newly formed titanium layer to oxygen-bearing gases by transferring said wafer through a sealed central chamber which is interconnected to both said vacuum deposition chamber and said sealed annealing chamber;
f) annealing the titanium-coated silicon semiconductor wafer in a nitrogen-bearing atmosphere in said annealing station, and in the substantial absence of oxygen-bearing gases, at a first temperature ranging from about 600°C to about 675°C for a period of time ranging from about 20 seconds to about 60 seconds by raising the temperature of said wafer at a rate within a range of from about 5°C/second to about 150°C/second to form said titanium silicide, as well as to form titanium nitride over said titanium silicide which inhibits migration of underlying silicon to the surface, and to react substantially all of the titanium overlying silicon oxide (SiO₂) regions on said wafer to form titanium nitride, whereby subsequent annealing of said wafer at a higher temperature will not result in reaction between said silicon oxide and unreacted titanium overlying said silicon oxide; and
g) raising the wafer temperature at a rate within a range of from about 5°C/second to about 150°C/second to a second temperature ranging from about 800°C to about 900°C to further anneal said wafer for an additional time period ranging from about 20 to about 60 seconds to convert said titanium silicide into a stable phase.

The process of the above special aspects can advantageously include the further step of etching said wafer, after said annealing step, to remove titanium nitride from said wafer.

## Claims

1. A process for forming a conductive layer of titanium silicide on a silicon semiconductor wafer, comprising the steps of:
cleaning the wafer to remove oxides and other materials from the silicon surface;
transferring said cleaned wafer to a vacuum deposition chamber in the substantial absence of oxygen and/or oxygen-bearing gases such that the wafer is maintained in an atmosphere that contains less than 10 ppm oxygen;
forming a titanium layer over the wafer by vacuum deposition in said vacuum deposition chamber in the substantial absence of oxygen and/or oxygen-bearing gases;
transferring said titanium coated wafer to a sealed annealing chamber without substantially exposing the newly formed titanium layer to oxygen and/or oxygen bearing gases; and
annealing the titanium coated silicon semiconductor wafer in a nitrogen bearing atmosphere containing at least 10 volume % nitrogen, the whole process being carried out in a single set up and in the substantial absence of oxygen and/or oxygen bearing gases, to form a stable phase of titanium silicide on said wafer and to form a layer of titanium nitride over said titanium silicide and over a silicon oxide surface on said wafer which inhibits migration of underlying silicon to the surface; wherein said annealing step comprises annealing said wafer at a first temperature sufficient to form said titanium silicide and said titanium nitride but insufficient to cause decomposure of adjacent silicon oxide material to form oxygen which reacts with the titanium to interfere with the titanium nitride reaction all titanium overlying silicon oxide surfaces being reacted with nitrogen to form titanium nitride at said first temperature; and wherein said annealing step additionally comprises further annealing of said wafer at a second temperature sufficient to convert the C49 phase titanium silicide formed during the first anneal into C54 phase titanium silicide.

2. The process of claim 1, said first temperature ranging from 500°C up to 695°C, preferably 600°C to 675°C for a time period ranging preferably from 20 seconds to 60 seconds.

3. The process of claim 1 or 2, said second temperature ranging from 800°C to 900°C for an additional time period ranging preferably from 20 to 60 seconds.

4. The process of any of the preceding claims, wherein said titanium layer is formed in a thickness of 10 nm to 500 nm (100 to 5000 Å).

5. The process of any of the preceding claims, which further includes reacting all of the titanium overlying silicon oxide (SiO₂) regions on said wafer with nitrogen in said annealing chamber during said annealing at said first temperature to form titanium nitride whereby subsequent annealing of said wafer at said second higher temperature will not result in reaction between said silicon oxide and unreacted titanium overlying said silicon oxide.

6. The process of any of the preceding claims, wherein the wafer is initially heated to the first temperature range and/or after the annealing in the first temperature range, said annealing temperature is raised from said first temperature range to said second temperature range.

7. The process of claim 6, wherein said initial heating of the wafer to the first temperature range and/or the raising of the temperature from said first temperature range up to said second temperature range is effected by raising the temperature of said wafer at a rate of from about 5°C/second to about 150°C/second.

8. The process of any of the preceding claims, wherein said nitrogen-bearing atmosphere in said annealing chamber is maintained, during said annealing in said first temperature range is effected at a pressure ranging from 133.3 · 10⁻³ hPa (100 milliTorr) to 1064 · 10⁻³ hPa (800 milliTorr) while flowing one or more nitrogen-bearing gases into said chamber, preferably at a rate ranging from about 500 to 10,000 sccm.

9. The process of any of the preceding claims, which comprises the further steps of:
a. cleaning said wafer in a cleaning chamber using a gaseous mixture which includes at least one reactive gas while maintaining an rf plasma in said cleaning chamber to remove oxides and other materials from the silicon surfaces thereon prior to said titanium deposition step; and
b. transferring said cleaned wafer from said cleaning chamber to said vacuum deposition without substantially exposing said cleaned wafer to oxygen and/or one or more oxygen-bearing gases.

10. The process of claim 9, wherein said cleaning step further comprises flowing into said cleaning chamber a gaseous mixture containing at least one reactive gas at a rate of from 2 to 500 sccm reactive gas and from 10 to 1000 sccm carrier gas while maintaining said plasma, preferably at a power ranging from 20 to 500 watts for a period of time ranging from 1 to 500 seconds.

11. The process of any of the preceding claims, wherein the transfer of the titanium-coated wafer to the annealing chamber and/or the transfer of the cleaned wafer to the vacuum deposition chamber is effected through a further chamber interconnected to both the vacuum deposition chamber and the annealing chamber and/or the cleaning chamber and the vacuum deposition chamber, said further chamber being maintained during said transfer at a pressure ranging from 1.33·10⁻⁹ to 1.33·10⁻⁵ hPa (10⁻⁹ to 10⁻⁵ Torr) to avoid substantially exposing the cleaned wafer and/or the newly formed titanium layer to oxygen and/or oxygen bearing gases.

12. The process of any of the preceding claims including the further step of etching said wafer, after said annealing step, to remove titanium nitride from said wafer.

## Patentansprüche

1. Verfahren zur Bildung einer leitenden Schicht aus Titansilicid auf einem Siliciumhalbleiterwafer mit folgenden Schritten:
Reinigung des Wafers zur Entfernung von Oxiden und anderen Materialien von der Siliciumoberfläche;
Übertragen des gereinigten Wafers zu einer Vakuumaufdampfungskammer in wesentlicher Abwesenheit von Sauerstoff und/oder sauerstoffhaltigen Gasen, so daß der Wafer in einer Atmosphäre mit weniger als 10 ppm Sauerstoff gehalten wird;
Bildung einer Titanschicht über dem Wafer durch Vakuumaufdampfung in der Vakuumaufdampfungskammer in wesentlicher Abwesenheit von Sauerstoff und/oder sauerstoffhaltigen Gasen;
Übertragen des titanbeschichteten Wafers zu einer abgedichteten Glühkammer, ohne daß die neu gebildete Titanschicht im wesentlichen Sauerstoff und/oder sauerstoffhaltigen Gasen ausgesetzt wird; und
Glühen des titanbeschichteten Siliciumhalbleiterwafers in einer stickstoffhaltigen Atmosphäre mit mindestens 10 Vol% Stickstoff, wobei das gesamte Verfahren in einem einzigen Schritt und in wesentlicher Abwesenheit von Sauerstoff und/oder sauerstoffhaltigen Gasen durchgeführt wird, um eine stabile Phase von Titansilicid auf dem Wafer zu bilden und eine Schicht Titannitrid über dem Titansilicid und über einer Siliciumoxidoberfläche auf dem Wafer zu bilden, wodurch darunterliegendes Silicium daran gehindert wird, an die Oberfläche zu wandern; wobei der Glühschritt das Glühen des Wafers bei einer ersten Temperatur, welche ausreicht, um das Titansilicid und das Titannitrid zu bilden, jedoch nicht ausreicht, um eine Zersetzung von benachbartem Siliciumoxidmaterial zu bewirken, um Sauerstoff zu bilden, welcher mit dem Titan reagiert, um die Titannitridreaktion zu beeinflussen, umfaßt, wobei das gesamte Titan über Siliciumoxidoberflächen mit Stickstoff zur Bildung von Titannitrid bei der ersten Temperatur umgesetzt wird; und wobei der Glühschritt darüber hinaus ein weiteres Glühen des Wafers bei einer zweiten Temperatur umfaßt, welche ausreicht, um das während des ersten Glühens gebildete Titansilicid der C49-Phase in Titansilicid der C54-Phase umzuwandeln.

2. Verfahren gemäß Anspruch 1, bei dem die erste Temperatur über einen Zeitraum im Bereich von vorzugsweise 20 Sekunden bis 60 Sekunden im Bereich von 500°C bis 695°C, vorzugsweise 600°C bis 675°C, liegt.

3. Verfahren gemäß Anspruch 1 oder 2, wobei die zweite Temperatur über einen zusätzlichen Zeitraum im Bereich von vorzugsweise 20 bis 60 Sekunden im Bereich von 800°C bis 900°C liegt.

4. Verfahren gemäß einem der vorhergehenden Ansprüche, bei dem die Titanschicht mit einer Dicke von 10 nm bis 500 nm (100 bis 5000 Å) ausgebildet ist.

5. Verfahren gemäß einem der vorhergehenden Ansprüche, das des weiteren das Umsetzen des gesamten Titans über den Siliciumoxid (SiO₂)-Bereichen auf dem Wafer mit Stickstoff in der Glühkammer während des Glühens bei der ersten Temperatur, um Titannitrid zu bilden, umfaßt, wobei anschließendes Glühen des Wafers bei der zweiten höheren Temperatur nicht zur Reaktion zwischen dem Siliciumoxid und unreagiertem Titan über dem Siliciumoxid führt.

6. Verfahren gemäß einem der vorhergehenden Ansprüche, bei dem der Wafer anfänglich auf den ersten Temperaturbereich erwärmt wird und/oder nach dem Glühen in dem ersten Temperaturbereich die Glühtemperatur von dem ersten Temperaturbereich auf den zweiten Temperaturbereich erhöht wird.

7. Verfahren gemäß Anspruch 6, bei dem die anfängliche Erwärmung des Wafers auf den ersten Temperaturbereich und/oder die Erhöhung der Temperatur von dem ersten Temperaturbereich bis zum zweiten Temperaturbereich durch Erhöhen der Temperatur des Wafers mit einer Geschwindigkiet von etwa 5°C/Sekunde bis etwa 150°C/Sekunde erfolgt.

8. Verfahren gemäß einem der vorhergehenden Ansprüche, -bei dem die stickstoffhaltige Atmosphäre in der Glühkammer aufrechterhalten wird, während das Glühen in dem ersten Temperaturbereich bei einem Druck im Bereich von 133,3 · 10⁻³ hPa (100 Millitorr) bis 1064 · 10⁻³ hPa (800 Millitorr) erfolgt, während ein oder mehrere stickstoffhaltige Gase in die Kammer strömen, vorzugsweise bei einer Rate im Bereich von etwa 500 bis 10000 sccm.

9. Verfahren gemäß einem der vorhergehenden Ansprüche, das folgende weitere Schritte umfaßt:
a. Reinigung des Wafers in einer Reinigungskammer unter Verwendung eines Gasgemisches mit mindestens einem reaktiven Gas unter Aufrechterhaltung eines rf-Plasmas in der Reinigungskammer, um von den Siliciumoberflächen Oxide und andere Materialien, welche sich darauf befinden, zu entfernen, bevor der Titanaufdampfungsschritt erfolgt; und
b. Übertragen des gereinigten Wafers von der Reinigungskammer zu der Vakuumaufdampfung, ohne daß der gereinigte Wafer im wesentlichen Sauerstoff und/oder einem oder mehreren sauerstoffhaltigen Gasen ausgesetzt wird.

10. Verfahren gemäß Anspruch 9, bei dem der Reinigungsschritt des weiteren das Einströmen in die Reinigungskammer eines Gasgemisches mit mindestens einem reaktiven Gas mit einer Rate von 2 bis 500 sccm reaktivem Gas und 10 bis 1000 sccm Trägergas umfaßt, während das Plasma aufrechterhalten wird, vorzugsweise mit einer Leistung im Bereich von 20 bis 500 Watt über einen Zeitraum im Bereich von 1 bis 500 Sekunden.

11. Verfahren gemäß einem der vorhergehenden Ansprüche, bei dem die Übertragung des titanbeschichteten Wafers zur Glühkammer und/oder die Übertragung des gereinigten Wafers zur Vakuumaufdampfungskammer durch eine weitere Kammer erfolgt, welche sowohl mit der Vakuumaufdampfungskammer als auch der Glühkammer und/oder der Reinigungskammer als auch der Vakuumaufdampfungskammer verbunden ist, wobei die weitere Kammer während der Übertragung auf einem Druck im Bereich von 1,33·10⁻⁹ bis 1,33·10⁻⁵ hPa (10⁻⁹ bis 10⁻⁵ Torr) gehalten wird, um zu vermeiden, daß der gereinigte Wafer und/oder die neu gebildete Titanschicht im wesentlichen Sauerstoff und/oder sauerstoffhaltigen Gasen ausgesetzt wird.

12. Verfahren gemäß einem der vorhergehenden Ansprüche mit dem weiteren Schritt des Ätzens des Wafers nach dem Glühschritt zur Entfernung von Titannitrid von dem Wafer.

## Revendications

1. Procédé de formation d'une couche conductrice ae siliciure de titane sur une plaquette de semi-conducteur en silicium, comprenant les étapes consistant à :
nettoyer la plaquette pour éliminer les oxydes et les autres matériaux présents sur la surface en silicium ;
transférer ladite plaquette nettoyée vers une chambre de dépôt sous vide, sensiblement en l'absence d'oxygène et/ou de gaz contenant de l'oxygène, de sorte que la plaquette est maintenue dans une atmosphère qui contient moins de 10 ppm d'oxygène ;
former une couche de titane sur la plaquette en effectuant un dépôt sous vide dans ladite chambre de dépôt sous vide, sensiblement en l'absence d'oxygène et/ou de gaz contenant de l'oxygène ;
transférer ladite plaquette revêtue de titane vers une chambre de recuit fermée hermétiquement, sensiblement sans exposer la couche de titane nouvellement formée à de l'oxygène et/ou à des gaz contenant de l'oxygène ; et
recuire la plaquette de semi-conducteur en silicium, revêtue de titane, dans une atmosphère contenant de l'azote, qui contient au moins 10% en volume d'azote, l'ensemble du procédé étant mis en oeuvre en une seule étape et sensiblement en l'absence d'oxygène et/ou de gaz contenant de l'oxygène, pour former une phase stable de siliciure de titane sur ladite plaquette et pour former une couche de nitrure de titane sur ledit siliciure de titane et sur une surface de ladite plaquette composée d'oxyde de silicium qui empêche la migration du silicium sous-jacent vers la surface ; procédé dans lequel ladite étape de recuit consiste à recuire ladite plaquette à une première température qui est suffisante pour former ledit siliciure de titane et ledit nitrure de titane, mais insuffisante pour entraîner une décomposition du matériau en oxyde de silicium adjacent et former de l'oxygène qui réagirait avec le titane et interfèrerait avec la réaction de formation de nitrure de titane, tout le titane recouvrant les surfaces en oxyde de silicium réagissant avec l'azote pour former du nitrure de titane à ladite première température ; et dans lequel ladite étape de recuit comprend en outre l'étape consistant à recuire ladite plaquette à une seconde température qui est suffisante pour convertir le siliciure de titane en phase C49, qui s'est formé au cours du premier recuit, en siliciure de titane en phase C54.

2. Procédé selon la revendication 1, dans lequel ladite première température est comprise entre 500°C et 695°C, de préférence entre 600°C et 675°C, pendant une période de temps qui est de préférence comprise entre 20 secondes et 60 secondes.

3. Procédé selon la revendication 1 ou 2, dans lequel ladite seconde température est comprise entre 800°C et 900°C, pendant une période de temps supplémentaire qui est de préférence comprise entre 20 et 60 secondes.

4. Procédé selon l'une quelconque des revendications précédentes, dans lequel ladite couche de titane est formée en une épaisseur comprise entre 10 nm et 500 nm (100 à 5000 Å).

5. Procédé selon l'une quelconque des revendications précédentes, comprenant en outre l'étape consistant à faire réagir toutes les régions formées de titane recouvrant l'oxyde de silicium (SiO₂), présentes sur ladite plaquette, avec de l'azote, dans ladite chambre de recuit, pendant ledit recuit à ladite première température, pour former du nitrure du titane, de sorte que le recuit ultérieur de ladite plaquette à ladite seconde température, qui est plus élevée, ne provoquera pas de réaction entre ledit oxyde de silicium et le titane recouvrant ledit oxyde de silicium et qui n'aurait pas réagi.

6. Procédé selon l'une quelconque des revendications précédentes, dans lequel la plaquette est initialement portée à la première gamme de températures et/ou dans lequel, après le recuit dans la première gamme de températures, ladite température de recuit est portée de ladite première gamme de températures à ladite seconde gamme de températures.

7. Procédé selon la revendication 6, dans lequel ledit chauffage initial de la plaquette jusqu'à la première gamme de températures et/ou l'élévation de la température de la première gamme de températures à la seconde gamme de températures, sont effectués en augmentant la température de ladite plaquette à une vitesse comprise entre environ 5°C/s et environ 150°C/s.

8. Procédé selon l'une quelconque des revendications précédentes, dans lequel ladite atmosphère contenant de l'azote est maintenue de préférence à un débit compris entre environ 500 et 10 000 cm³/mn dans ladite chambre de recuit, tandis que ledit recuit à ladite première gamme de températures est effectué sous une pression qui va de 133,3 x 10⁻³ hPa (100 milliTorr) à 1064 x 10⁻³ hPa (800 milliTorr) et que l'on fait circuler un ou plusieurs gaz contenant de l'azote dans ladite chambre.

9. Procédé selon l'une quelconque des revendications précédentes, comprenant en outre les étapes consistant à :
(a) nettoyer ladite plaquette dans une chambre de nettoyage à l'aide d'un mélange gazeux qui comprend au moins un gaz réactif, tout en maintenant un plasma à haute fréquence dans ladite chambre de nettoyage pour éliminer les oxydes et les autres matériaux présents sur les surfaces en silicium de ladite plaquette, avant ladite étape de dépôt de titane ; et
(b) transférer ladite plaquette nettoyée depuis ladite chambre de nettoyage vers ladite chambre de dépôt sous vide, sensiblement sans exposer ladite plaquette nettoyée à de l'oxygène et/ou à un ou plusieurs gaz contenant de l'oxygène.

10. Procédé selon la revendication 9, dans lequel ladite étape de nettoyage comprend en outre l'étape consistant à faire circuler dans ladite chambre de nettoyage un mélange gazeux contenant au moins un gaz réactif, à un débit de gaz réactif qui va de 2 à 500 cm³/mn et à un débit de gaz porteur qui va de 10 à 1 000 cm³/mn, tout en maintenant ledit plasma, de préférence, à une puissance comprise entre 20 et 500 watts, pendant une période de temps qui va de 1 à 500 secondes.

11. Procédé selon l'une quelconque des revendications précédentes, dans lequel le transfert de la plaquette revêtue de titane vers la chambre de recuit et/ou le transfert de la plaquette nettoyée vers la chambre de dépôt sous vide, sont effectués par l'intermédiaire d'une autre chambre interconnectée à la fois à la chambre de dépôt sous vide et à la chambre de recuit et/ou à la chambre de nettoyage et à la chambre de dépôt sous vide, ladite autre chambre étant maintenue, au cours dudit transfert, sous une pression comprise entre 1,33 x 10⁻⁹ et 1,33 x 10⁻⁵ hPa (10⁻⁹ à 10⁻⁵ Torr) pour éviter sensiblement d'exposer la plaquette nettoyée et/ou la couche de titane nouvellement formée à de l'oxygène et/ou à des gaz contenant de l'oxygène.

12. Procédé selon l'une quelconque des revendications précédentes, comprenant en outre l'étape consistant à décaper ladite plaquette, après ladite étape de recuit, pour éliminer le nitrure de titane de ladite plaquette.
